(19) Europäisches Patentamt
European Patent Office
Office européen des brevets

(11) Veröffentlichungsnummer : **0 038 477**
**B1**

# (12) EUROPÄISCHE PATENTSCHRIFT

(45) Veröffentlichungstag der Patentschrift : **04.07.84**

(51) Int. Cl.[3] : **G 03 F 7/10**, B 41 N 1/00, G 03 C 1/68

(21) Anmeldenummer : **81102691.3**

(22) Anmeldetag : **09.04.81**

## (54) Zur Herstellung von Druck- und Reliefformen geeignete Mehrschichtelemente.

(30) Priorität : **22.04.80 DE 3015419**

(43) Veröffentlichungstag der Anmeldung : **28.10.81 Patentblatt 81/43**

(45) Bekanntmachung des Hinweises auf die Patenterteilung : **04.07.84 Patentblatt 84/27**

(84) Benannte Vertragsstaaten : **BE CH DE FR GB IT LI NL**

(56) Entgegenhaltungen : **EP-A- 0 005 750**
**Die Akte enthält technische Angaben, die nach dem Eingang der Anmeldung eingereicht wurden und die nicht in dieser Patentschrift enthalten sind.**

(73) Patentinhaber : **BASF Aktiengesellschaft**
**Carl-Bosch-Strasse 38**
**D-6700 Ludwigshafen (DE)**

(72) Erfinder : **Hartmann, Heinrich, Dr.**
**Weinheimer Strasse 46**
**D-6703 Limburgerhof (DE)**
Erfinder : **Hoffmann, Gerhard, Dr.**
**Pappelstrasse 22**
**D-6701 Otterstadt (DE)**
Erfinder : **Lenz, Werner, Dr.**
**Heinrich-Baermann-Strasse 14**
**D-6702 Bad Duerkheim (DE)**
Erfinder : **Lynch, John, Dr.**
**Bachusstrasse 15**
**D-6520 Monsheim (DE)**
Erfinder : **Naarmann, Herbert, Dr.**
**Haardtblick 15**
**D-6719 Wattenheim (DE)**

**EP 0 038 477 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft zur Herstellung von Druck- und Reliefdruckformen geeignete Mehrschichtelemente, die eine verbesserte Stabilität bei der Verarbeitung, insbesondere bei der Trocknung und Nachbelichtung aufweisen.

Mit Wasser oder wäßrigen Lösungen entwickelbare Mehrschichtelemente für die Herstellung von photopolymeren Druck- und Reliefformen sind an sich bekannt und vielfach beschrieben (vgl. z. B. GB-A-834 337 oder US-A-3 877 939). Bei der Verarbeitung solcher wasserentwickelbarer photopolymerer Druck- und Reliefplatten beobachtet man bei der Nachbehandlung der Druck- und Reliefformen, das sind vor allem die Trocknung und Nachbelichtung, Trocknungsschäden der Klischees in Form von Ablösungen der Photopolymerschicht von der Trägerplatte. Diese insbesondere bei der Trocknung mit Infrarotstrahlern auftretenden Trocknungsschäden treten in allen Reliefelementen auf, also in Volltönen, Rasterfeldern, Linien und Punkten. Diese Trocknungsschäden werden schon bei Nachbehandlungs- und Trocknungsbedingungen erhalten, bei denen noch keine ausreichende Härtung des Reliefs erreicht wird. D. h., um eine geforderte Qualität dieser Photopolymerschichten zu gewährleisten, müßten die Nachbehandlungsbedingungen in bezug auf Temperatur, Trocknungsdauer und Strahlungsleistung verschärft werden. Durch die Trocknungsschäden werden die Platten weitgehend unbrauchbar. Mit Platten, die unter milderen Bedingungen ohne solche Schäden produziert werden, kann keine gute Druckqualität und keine hohe Druckleistung erhalten werden.

Aus der EP-A-5750 sind photopolymerisierbare Gemische bekannt, die neben einem alkalilöslichen Bindemittel und Photoinitiatoren als Monomere spezielle Polyurethane mit zwei endständigen Acrylat- oder Methacrylat-Gruppen enthalten. Diese photopolymerisierbaren Gemische eignen sich insbesondere zur Herstellung von Photoresistschichten und Trockenfilmresisten und sollen einen verminderten kalten Fluß, eine verminderte Sprödigkeit im unbelichteten und belichteten Zustand sowie auch eine gute Haftung auf metallischen Untergründen, z. B. Kupfer, wie sie bei der Herstellung von Photoresisten Anwendung finden, aufweisen. Auf die Herstellung von Haftschichten für Mehrschichtenelemente, die für die Herstellung von Druck- und Reliefformen geeignet sind, findet sich in dieser Entgegenhaltung kein Hinweis.

Der vorliegenden Erfindung lag die Aufgabe zugrunde, bei mit Wasser oder mit wäßrigen Lösungen entwickelbaren photopolymeren Elementen, deren photoempfindliche Schicht mindestens ein hydrophiles polymeres Bindemittel enthält, das Auftreten solcher insbesonder bei der Trocknung mit Infrarotstrahlen auftretenden Trocknungsschäden zu verhindern, auch bei für gute Platteneigenschaften erforderlichen verschärften Nachbehandlungsbedingungen.

Es wurde nun gefunden, daß zur Herstellung von Druck- und Reliefformen geeignete Mehrschichtelemente mit

(a) einer photoempfindlichen Schicht einer in Wasser oder in wäßriger Lösung löslichen Mischung von

($a_1$) mindestens einem hydrophilen polymeren Bindemittel mit

($a_2$) mindestens einem damit verträglichen photopolymerisierbaren ethylenisch ungesättigten Monomeren sowie

($a_3$) einem durch aktinisches Licht aktivierbaren Fotoinitiator,

(b) einer dimensionsstabilen Trägerschicht und

(c) einer dünnen Zwischenschicht zwischen den Schichten (a) und (b), die gebildet wird aus einer Mischung, enthaltend

($c_1$) mindestens ein mit dem polymeren Bindemittel ($a_1$) der Schicht (a) verträgliches polymeres Bindemittel,

($c_2$) mindestens ein damit verträgliches photopolymerisierbares ethylenisch ungesättigtes Monomeres sowie

($c_3$) gegebenenfalls einen durch aktinisches Licht aktivierbaren Fotoinitiator,

die gewünschten Eigenschaften weitgehend zeigen, wenn die die Zwischenschicht (c) bildende Mischung als polymeres Bindemittel ($c_1$) zu mindestens 30 Gew.%, bezogen auf den Bindemittelanteil dieser Mischung, und bevorzugt überwiegend oder ganz ein Umsetzungsprodukt eines Polyvinylalkohols mit Acryl- und/oder Methacrylsäureanhydrid mit 3 bis 30 Gew.% an seitenständigen Acryloyl- und/oder Methacryloyl-Gruppen im Umsetzungsprodukt aufweist, als Monomer-Komponente 1 bis 25 Gew.%, bezogen auf die Mischung von ($c_1$) und ($c_2$), mindestens eines Monomeren aus der Gruppe der Hydroxyalkylacrylate mit 2 oder 3 C-Atomen im Alkylrest, der Hydroxyalkyl-methacrylate mit 2 oder 3 C-Atomen im Alkylrest und der Monomeren der Formel

$$\begin{array}{r} CH_2=CR^1-COO-(-CH_2-CHR^3-O-)_m-CO-NH \\ X \\ CH_2=CR^2-COO-(-CH_2-CHR^4-O-)_n-CO-NH \end{array}$$

enthält, wobei bedeuten

$R^1$, $R^2$, $R^3$, $R^4$ = jeweils für sich, ein H-Atom oder eine $C_1$-$C_8$-Alkylgruppe, wobei die Reste $R^1$ bis $R^4$ gleich oder verschieden sein können

X = $C_2$-$C_7$-Alkylenrest, 2-wertiger aromatischer $C_6$-$C_{10}$-Kohlenwasserstoffrest oder Isophoronylen-Rest

n, m = Zahlen von 1 bis 4, wobei n und m gleich oder verschieden sein können,

wobei die Zwischenschicht (c) nach Auftrag der sie bildenden Mischung auf die Trägerschicht (b) bei einer Temperatur zwischen 110 und 220 °C getrocknet und eingebrannt wurde.

Die Verwendung von Mehrschichtelementen mit den erfindungsgemäßen Zwischenschichten für bildmäßige Belichtungen mit aktinischem Licht und anschließendes Auswaschen der unbelichteten Bereiche erlaubt die Herstellung von Druck- und Reliefplatten, die bei der Nachbehandlung keine Trocknungsschäden der Klischees aufweisen.

Als photoempfindliche Schicht (a) einer in Wasser oder wäßriger Lösung löslichen Mischung von ($a_1$) mindestens einem hydrophilen polymeren Bindemittel mit ($a_2$) mindestens einem damit verträglichen photopolymerisierbaren ethylenisch ungesättigten Monomeren und ($a_3$) einem Fotoinitiator kommen beispielsweise Mischungen in Frage, wie sie z. B. in den britischen Patentschriften 786 119, 834 337, 835 849, 1 233 883, 1 351 475 oder 1 416 440 beschrieben sind, auf deren Offenbarung diesbezüglich ausdrücklich Bezug genommen wird, wobei als hydrophile polymere Bindemittel ($a_1$) wasserlösliche Polyvinylalkohole und dessen wasserentwickelbare Copolymere und Derivate wie dessen Ester, Ether oder Acetale bevorzugt sind. Als Monomere ($a_2$) haben sich Hydroxylgruppen enthaltende (Meth)Acrylate, wie Hydroxyethyl(meth)acrylat, sowie Mono- und Di(meth)acrylate von aliphatischen Glykolen, wie z. B. Mono- und Di-(meth)acrylate von Ethylenglykol, Butandiol-1,4, Diethylenglykol und Polyethylenglykolen mit Molekulargewichten bis ca. 500, besonders bewährt.

Als polymere Bindemittel ($c_1$) für die Zwischenschicht (c) kommen solche in Frage, die mit dem polymeren Bindemittel der Schicht (a) verträglich sind. Bevorzugt sind hierbei Polyvinylalkohol, Vinylalkohol-Copolymere und deren wasserentwickelbare Derivate.

Mindestens 30 Gew.% und vorzugsweise mehr als 50 Gew.% dieser polymeren Bindemittel ($c_1$) bestehen in den erfindungsgemäßen Mehrschichtelementen aus einem mit Acrylsäureanhydrid und/oder Methacrylsäureanhydrid veresterten Polyvinylalkohol, wobei das Umsetzungsprodukt 3 bis 30 Gew.% und insbesondere 5 bis 20 Gew.% an seitenständigen Acryloyl- und/oder Methacryloylgruppen enthält. Die Herstellung solcher Umsetzungsprodukte ist bekannt und z. B. in der DE-C-10 65 621 oder in Houben-Weyl, Methoden der organischen Chemie, 6. Auflage, G. Thieme-Verlag, Stuttgart 1961, Band 14/2, Seite 725 ff. beschrieben. Bevorzugt sind in Lösung der Reaktanten hergestellte Produkte. Die als Ausgangsprodukte für die Umsetzung dienenden Polyvinylalkohole sind bevorzugt teilverseifte Polyvinylester wie Polyvinylacetate mit einem Verseifungsgrad von 78 bis 98 % und insbesondere 78 bis 88 % und einem mittleren Polymerisationsgrad von 350 bis 2 500 und insbesondere 400 bis 2 150.

Die erfindungsgemäßen Mehrschichtelemente enthalten in der die Zwischenschicht (c) bildenden Mischung ferner in einer Menge von 1 bis 25 Gew.% und insbesondere 4 bis 20 Gew.%, bezogen auf die Summe der Mengen von ($c_1$) und ($c_2$), ein oder mehr der Hydroxyalkyl(meth)acrylate, wie z.B. β-Hydroxyethylacrylat, β-Hydroxypropylacrylat oder β-Hydroxyethylmethacrylat und/oder ein oder mehr Monomere der oben angegebenen allgemeinen Formel. Vorzugsweise stellen in dieser Formel die Reste $R^1$ bis $R^4$ ein Wasserstoff-Atom, ein Methyl-, Ethyl-, Propyl- oder Butyl-Gruppe, insbesondere ein Wasserstoffatom, eine Methyl- oder eine Ethyl-Gruppe dar. X ist in dieser Formel insbesondere die Hexamethylen-, Toluylen- oder Isophoronylen-Gruppe. Bevorzugte Monomere des Typs der angegebenen allgemeinen Formel sind Umsetzungsprodukte von 2 Molen von β-Hydroxyethyl- oder β-Hydroxypropylacrylat oder -methacrylat mit 1 Mol Hexamethylendiisocyanat, Toluylendiisocyanat oder Isophorondiisocyanat, doch sind auch z. B. die Umsetzungsprodukte von Diethylenglykol- oder Triethylenglykolmonoacrylat oder -monomethacrylat mit entsprechenden Diisocyanaten geeignet.

Sofern der Zwischenschicht (c) ein Photoinitiator zugesetzt wird, beträgt dessen Menge 0,1 bis 10 Gew.% und bevorzugt 0,5 bis 5 Gew.%, bezogen auf die Gesamtmenge der Komponenten der Zwischenschicht (c). Als Photoinitiatoren kommen dabei alle bekannten und gebräuchlichen Photoinitiatoren in Betracht.

Die die Zwischenschicht (c) bildende Mischung wird nach bekannten Verfahren schichtförmig auf die dimensionsstabile Trägerschicht (b) so aufgebracht, daß die Stärke der Zwischenschicht (c) nach dem Einbrennen bzw. Trocknen bei 110 bis 220 °C und insbesondere bei 140 bis 170 °C zweckmäßigerweise 2 bis 30 µm und insbesondere 5 bis 10 µm beträgt, wobei die bevorzugte Einbrennzeit bei 3 bis 10 Minuten liegt.

Als dimensionsstabile Trägerschichten (b) kommen vor allem die für die Herstellung von Relief- und Druckplatten üblichen metallischen Unterlagen, wie Stahl- oder Aluminiumbleche in Frage, die in an sich bekannter Art mechanisch, chemisch oder durch Versehen mit einer Haftgrundierung vorbehandelt sein können. Gut bewährt haben sich Stahlbleche, die mit einem Haftgrundlack, wie er in der DE-A-15 97 515 beschrieben ist, in einer Schichtstärke von 10 bis 40 µm und insbesondere 15 bis 25 µm beschichtet wurden.

Auf die photoempfindliche Schicht (a) der erfindungsgemäßen Mehrschichtelemente kann gegebenenfalls noch in bekannter Weise eine Schutz- oder Deckfolie, beispielsweise aus Polyester, aufgebracht

sein, die je nach Bedarf vor oder nach der Belichtung der Mehrschichtelemente mit aktinischem Licht abgezogen werden kann.

Die in den folgenden Beispielen und Vergleichsversuchen genannten Teile und Prozente beziehen sich, soweit nicht anders angegeben, auf das Gewicht. Teile verhalten sich zu Volumenteilen wie Kilogramm zu Liter.

Beispiel 1

1.1 180 Teile eines teilweise verseiften Polyvinylacetats (Verseifungsgrad 82 Mol.%, Durchschnittsmolekulargewicht 25 000) werden in 750 Volumenteilen Methylenchlorid bei Raumtemperatur aufgeschlämmt und mit 20 Teilen Methacrylsäureanhydrid versetzt. Das inhomogene Gemisch wird knapp 3 Stunden gerührt, wobei die Temperatur nicht über 50 °C ansteigt. Danach wird über eine Nutsche filtriert. Das abfiltrierte feuchte Umsetzungsprodukt wird anschließend 24 Stunden bei Raumtemperatur im Vakuum getrocknet.

1.2 Es wird eine 12 %ige Lösung einer Mischung aus 2 Teilen Benzoinäthyläther, 6 Teilen des Reaktionsproduktes aus 1 Mol Toluylendiisocyanat und 2 Molen β-Hydroxyethylmethacrylat und 92 Teilen des gemäß 1.1 hergestellten Polyvinylalkohol-Methacrylsäureanhydrid-Umsetzungsproduktes in einem Gemisch gleicher Teile von Wasser und Äthanol hergestellt. Die Lösung wird aud ein mit einem Polyurethan-Grundierlack gemäß DE-A-15 97 515 (hergestellt aus einem handelsüblichen hydroxylgruppenhaltigen Polyester aus 2,5 Mol Adipinsäure, 0,5 Mol Phthalsäure und 4 Mol 1,1,1-Trimethylolpropan durch Umsetzung mit einem durch Reaktion von 3 Molen Toluylendiisocyanat mit 1 Mol 1,1,1-Trimethylolpropan hergestellten Triisocyanat) vorbehandelten Stahlblech in einer solchen Stärke aufgetragen, daß nach 7 minutigem Trocknen bei 150 °C in einem Trockenschrank eine Zwischenschicht (c) mit einer Schichtstärke von 10 µm resultiert.

1.3 Für die Herstellung der photoempfindlichen Schicht (a) werden 291 Teile eines teilweise verseiften Polyvinylacetates (Verseifungsgrad 82 Mol.%, Durchschnittsmolekulargewicht 25 000) durch mehrstündiges Rühren in 294 Teilen Waser bei 90 °C gelöst. Nach Abkühlen auf 70 °C werden unter Rühren 200 Teile eines Gemisches aus 180 Teilen 2-Hydroxyäthylmethacrylat und 20 Teilen 1,1,1-Trimethylolpropantriacrylat, ferner 10 teilen Benzildimethylketal und 2 Teilen 2,6-Di-tert.-butyl-p-kresol zugegeben. Die homogene, viskose Lösung wird filtriert und unter reduziertem Druck entgast. Sie wird auf eine (später als Deckschicht wirkende) 125 µm starke Polyesterfolie schichtförmig so aufgetragen, daß nach 24-stündigem Trocknen bei Raumtemperatur eine 550 µm starke nicht klebende Schicht (a) resultiert.

1.4 Nach Anfeuchten der Schicht (a) sowie der Zwischenschicht (c) mit einem Wasser-Methanol-Gemisch wird das gemäß 1.3 hergestellte Zweischichtenelement mit der photoempfindlichen Schicht (a) auf die Zwischenschicht (c) der gemäß 1.2 mit der Zwischenschicht (c) versehenen Stahlplatte aufkaschiert und die Polyesterdeckschicht abgezogen.

Verschiedene Proben des resultierenden Mehrschichtelements werden verschieden lange bildmäßig belichtet. Bei den Proben werden dann die nichtbelichteten Anteile der Schichten (a) und (c) ausgewaschen und die resultierende Druckformen werden danach in einer mit Infrarotheizstäben versehenen Nachbehandlungsvorrichtung 2,5 Minuten bei 90 °C (die vom Temperaturfühler in der Vorrichtung angezeigte Umlufttemperatur liegt unter der Temperatur der Druckformoberfläche) getrocknet und nachbelichtet.

Anhand der Proben der resultierenden Reliefformen mit unterschiedlichen bildmäßigen Belichtungszeiten wird die Mindestbelichtungszeit für freistehende Punkte mit 0,3 mm Durchmesser, freistehende Linien von 0,15 mm Dicke und Raster mit einem Tonwert von 3 % und einer Rasterweite von 28 L/cm einer gemeinsamen Reliefhöhe 0,55 mm beurteilt. Die Mindestbelichtungszeit der nach diesem Beispiel hergestellten Druckplatten beträgt 70 Sekunden.

Die mit 70 Sekunden Belichtungszeit hergestellte Reliefform zeigt keinerlei Trocknungsschäden und die feinen Reliefelemente können mit den Fingern nicht ohne Gewalt entfernt werden.

Vergleichsversuch A

Es wird wie in Beispiel 1 verfahren, jedoch wird das gemäß Beispiel 1.3 hergestellte Zweischichtenelement mit der Seite der photoempfindlichen Schicht (a) auf das in Beispiel 1.2 angegebene mit einem Grundierlack versehene Stahlblech, das diesmal jedoch keine Zwischenschicht (c) aufweist, aufkaschiert. Das resultierende Mehrschichtenelement ist als Druckplatte nicht verwendbar, da sich nach kurzer Zeit die photoempfindliche Schicht (a) von selbst von dem grundierten Stahlblech ablöst.

Vergleichsversuch B

Es wird wie in Beispiel 1 angegeben verfahren, jedoch wird für die Herstellung der Zwischenschicht (c) gemäß 1.2 eine 12 %ige Lösung einer Mischung aus 2 Teilen Benzoinethylether, 9,8 Teilen β-Hydroxyethylmethacrylat und 88,2 Teilen eines verseiften Polyvinylacetats, wie es zur Herstellung der Aufzeichnungsschicht gemäß Beispiel 1.3 verwendet wird, angewandt. Es wird eine verarbeitbare Druckplatte erhalten, die — gemäß Beispiel 1.4 getestet — eine Mindestbelichtungszeit von 100

Sekunden aufweist. Die mit 100 Sekunden belichtete und wie in beispiel 1.4 angegeben nachbehandelte reliefform zeigt deutliche Trocknungsschäden, feine Reliefelemente zeigen Verzerrungserscheinungen und können leicht mit dem Finger vom Träger entfernt werden.

Beispiel 2

Es wird wie in Beispiel 1 verfahren, jedoch besteht die Zwischenschicht (c) aus 35,2 % eines teilverseiften Polyvinylacetats mit einem Verseifungsgrad von 82 % und einem mittleren Polymerisationsgrad von 500, 52,8 % eines Umsetzungsproduktes von 100 Teilen dieses teilverseiften Polyvinylacetats mit 15 Teilen Methacrylsäureanhydrid, 10 % des Umsetzungsprodukte von 2 Molen β-Hydroxypropylmethacrylat mit 1 Mol Isophorondiisocyanat und 2 % Benzoinisopropylether. Die damit analog Beispiel 1 hergestellten Druckplatten erfordern eine Mindestbelichtungszeit von 80 Sekunden und sind völlig frei von Trocknungsschäden. Die feinen Bildelemente sind auf dem Trägerblock gut verankert.

## Ansprüche

1. Zur Herstellung von Druck- und Reliefformen geeignete Mehrschichtelemente mit
(a) einer photoempfindlichen Schicht einer in Wasser oder wäßriger Lösung löslichen Mischung von
($a_1$) mindestens einem hydrophilen polymeren Bindemittel,
($a_2$) mindestens einem damit verträglichen photopolymerisierbaren ethylenisch ungesättigten Monomeren und
($a_3$) einem durch aktinisches Licht aktivierbaren Fotoinitiator,
(b) einer dimensionsstabilen Trägerschicht und
(c) einer dünnen Zwischenschicht zwischen Schicht (a) und Schicht (b) mit einer Mischung von
($c_1$) mindestens einem mit dem polymeren Bindemittel ($a_1$) der Schicht (a) verträglichen polymeren Bindemittel und
($c_2$) mindestens einem damit verträglichen photopolymerisierbaren ethylenisch ungesättigten Monomeren,
dadurch gekennzeichnet, daß das polymere Bindemittel ($c_1$) der Zwischenschicht (c) zu mindestens 30 Gew.%, bezogen auf die Gesamtmenge des Bindemittels ($c_1$), aus einem Umsetzungsprodukt eines Polyvinylakohols mit Acryl- und/oder Methacrylsäureanhydrid mit 3 bis 30 Gew.%, bezogen auf das Umsetzungsprodukt, an seitenständigen Acryloyl- und/oder Methacryloylgruppen besteht, die Zwischenschicht (c) als Monomeres ($c_2$) 1 bis 25 Gew.%, bezogen auf die Mischung von ($c_1$) und ($c_2$), eines Hydroxyalkylacrylats und/oder -methacrylats mit 2 oder 3 C-Atomen im Alkylrest und/oder eines Monomeren der Formel

$$\begin{array}{l} CH_2{=}CR^1{-}COO{-}({-}CH_2{-}CHR^3{-}O{-})_m{-}CO{-}NH \\ \hspace{6.2cm} X \\ CH_2{=}CR^2{-}COO{-}({-}CH_2{-}CHR^4{-}O{-})_n{-}CO{-}NH \end{array}$$

enthält, wobei bedeuten
$R^1$, $R^2$, $R^3$, $R^4$ = H, $C_1$-$C_8$-Alkyl, wobei $R^1$-$R^4$ gleich oder verschieden sein können,
X = ein $C_2$-$C_7$-Alkylenrest, ein 2-wertiger aromatischer $C_6$-$C_{10}$-Kohlenwasserstoffrest oder Isophoronylen-Rest
m, n = unabhängig voneinander Zahlen von 1-4, und die Zwischenschicht (c) nach dem Auftrag auf die Trägerschicht (b) bei einer Temperatur zwischen 110 und 220 °C getrocknet wurde.

2. Mehrschichtelemente gemäß Anspruch 1, dadurch gekennzeichnet, daß das Monomere ($c_2$) ein Umsetzungsprodukt aus 2 Molen β-Hydroxyethyl- oder β-Hydroxypropylacrylat oder -methacrylat und 1 Mol Hexamethylendiisocyanat, Toluylendiisocyanat oder Isophorondiisocyanat darstellt.

3. Mehrschichtelemente gemäß Anspruch 1 oder 2, dadurch gekennzeichnet, daß sie als Trägerschicht eine mechanisch, chemisch und/oder durch Versehen mit einer Haftgrundierung vorbehandelte metallische Unterlage aufweisen.

## Claims

1. A laminate suitable for the production of printing plates and relief plates, comprising
(a) a photosensitive layer of mixture, soluble in water or in an aqueous solution, of
($a_1$) at least one hydrophilic polymeric binder,
($a_2$) at least one photopolymerizable ethylenically unsaturated monomer compatible therewith,

and

($a_3$) a photoinitiator which can be activated by actinic light,

(b) a dimensionally stable base, and

(c) a thin intermediate layer between layers (a) and (b), which is formed from a mixture of

($c_1$) at least one polymeric binder which is compatible with the polymeric binder ($a_1$) of layer (a), and

($c_2$) at least one photopolymerizable ethylenically unsaturated monomer compatible with ($c_1$), wherein the polymeric binder ($c_1$) of intermediate layer (c) contains not less than 30 % by weight, based on the total amount of binder ($c_1$), of a reaction product of a polyvinyl alcohol with acrylic anhydride and/or methacrylic anhydride, which reaction product contains from 3 to 40 %, of its weight, of lateral acrylyl and/or methacrylyl groups, the inermediate layer (c) contains, as monomer ($c_2$) from 1 to 25 % by weight, based on the mixture of ($c_1$) and ($c_2$), of a hydroxyalkyl acrylate and/or methacrylate, where alkyl is of 2 or 3 carbon atoms, and/or monomer of the formula

$$\begin{array}{l} CH_2=CR^1-COO-(-CH_2-CHR^3-O-)_m-CO-NH \\ \qquad\qquad\qquad\qquad\qquad\qquad\qquad\quad\;\; X \\ CH_2=CR^2-COO-(-CH_2-CHR^4-O-)_n-CO-NH \end{array}$$

where $R^1$, $R^2$, $R^3$ and $R^4$ may be identical or different and each is H or $C_1$-$C_8$-alkyl, X is $C_2$-$C_7$-alkylene, a divalent aromatic $C_6$-$C_{10}$-hydrocarbon radical or isophoronylene, and m and n may be identical or different and are each integers from 1 to 4, and the intermediate layer (c), after its application to the base (b), has been dried at from 110° to 220 °C.

2. A laminate as claimed in claim 1, wherein the monomer ($c_2$) is a reaction product of 2 moles of β-hydroxyethyl acrylate or methacrylate or β-hydroxypropyl acrylate or methacrylate with 1 mole of hexamethylene diisocyanate, toluylene diisocyanate or isophorone diisocyanate.

3. A laminate as claimed in claim 1 or 2, wherein the base is a metal support which has been pretreated mechanically or chemically and/or provided with an adhesive layer.

**Revendications**

1. Eléments multi-couches, convenant pour la fabrication de formes d'impression et de formes en relief, comprenant

(a) une couche photosensible en un mélange soluble dans l'eau ou en solution aqueuse de

($a_1$) au moins un liant polymère hydrophile,

($a_2$) au moins un monomère à insaturation éthylénique photopolymérisable, compatible avec le liant ($a_1$),

($a_3$) un photo-initiateur activable par la lumière actinique,

(b) une couche support dimensionnellement stable et

(c) une mince couche intercalaire, placée entre la couche (a) et la couche (b), d'un mélange formé de

($c_1$) au moins un liant polymère compatible avec le liant polymère ($a_1$) de la couche (a) et de

($c_2$) au moins un monomère à insaturation éthylénique photopolymérisable, compatible avec le liant ($c_1$),

caractérisés en ce que le liant polymère ($c_1$) de la couche intercalaire (c) est composé à raison d'au moins 30 % de son poids d'un produit de la réaction d'un poly (alcool vinylique) et d'un anhydride d'acide acrylique et (ou) méthacrylique avec 3 à 30 % du poids du produit de réaction de groupes acryloyle et(ou) méthacryloyle terminaux, la couche intercalaire (c) contient en tant que monomère ($c_2$) entre 1 et 25 % du poids du mélange de ($c_1$) et de ($c_2$) d'un acrylate et(ou) d'un méthacrylate d'hydroxy-alkyle à radical alkyle en $C_2$ ou en $C_3$ et(ou) d'un monomère de la formule

$$\begin{array}{l} CH_2=CR^1-COO-(-CH_2-CHR^3-O-)_m-CO-NH \\ \qquad\qquad\qquad\qquad\qquad\qquad\qquad\quad\;\; X \\ CH_2=CR^2-COO-(-CH_2-CHR^4-O-)_n-CO-NH \end{array}$$

dans laquelle $R^1$, $R^2$, $R^3$ et $R^4$, qui peuvent être identiques ou différents, désignent chacun un atome d'hydrogène ou un radical alkyle en $C_1$ à $C_8$, X représente un groupe alkylène en $C_2$ à $C_7$, un groupe hydrocarboné aromatique bivalent en $C_6$ à $C_{10}$ ou un groupe isophoronylène et m et n valent, indépendamment l'un de l'autre, de 1 à 4, la couche intercalaire (c) ayant été séchée à une température entre 100 et 220 °C après son application sur la couche support (b).

2. Eléments multi-couches suivant la revendication 1, caractérisés en ce que le nomomère ($c_2$) est un produit de la réaction de deux moles d'acrylate ou de méthacrylate de β-hydroxy-éthyle ou de β-hydroxy-propyle avec une mole de diisocyanate d'hexaméthylène, de diisocyanate de toluylène ou de diisocyanate d'isophorone.

3. Eléments multi-couches suivant la revendication 1 ou la revendication 2, caractérisés en ce qu'ils comprennent comme couche support un support métallique prétraité par voie mécanique ou chimique et (ou) par application d'un apprêt d'accrochage.